# EUROPÄISCHE PATENTSCHRIFT

(11) **EP 3 824 323 B1**
(45) Veröffentlichungstag und Bekanntmachung des Hinweises auf die Patenterteilung: **03.05.2023**
(21) Anmeldenummer: 19718738.8
(22) Anmeldetag: 24.04.2019
(51) Int. Cl.: G01V 3/10, H03K 17/95

(54) **DETEKTOR ZUM DETEKTIEREN VON ELEKTRISCH LEITFÄHIGEM MATERIAL**
DETECTOR FOR DETECTING ELECTRICALLY CONDUCTIVE MATERIAL
DÉTECTEUR SERVANT À DÉTECTER DU MATÉRIAU ÉLECTRIQUEMENT CONDUCTEUR

(30) Priorität: 20.07.2018 EP 18184723
(43) Veröffentlichungstag der Anmeldung: 26.05.2021
(73) Patentinhaber: Frauscher Sensortechnik GmbH, 4774 St. Marienkirchen (AT)
(72) Erfinder: MADER, Günther, 4950 Altheim (AT)
(74) Vertreter: Epping - Hermann - Fischer
(86) Internationale Anmeldenummer: PCT/EP2019/060515
(87) Internationale Veröffentlichungsnummer: WO 2020/015876

(56) Entgegenhaltungen:
- EP-A1- 2 493 076
- EP-A1- 2 555 019
- EP-A1- 2 562 565
- DE-A1-102010 009 576
- US-A- 4 084 135
- US-A1- 2016 290 833

## Beschreibung

Es wird ein Detektor zum Detektieren von elektrisch leitfähigem Material angegeben.

Metalldetektoren können verwendet werden, um sich bewegende metallische Gegenstände zu detektieren. Dazu kann ein Metalldetektor einen Schwingkreis mit einer oder mehreren Spulen aufweisen. Die Bewegung eines metallischen Gegenstandes im Magnetfeld der Spule oder der Spulen führt zu einer Änderung der Impedanz der Spule oder der Spulen. Bei mehreren Spulen führt die Bewegung eines metallischen Gegenstandes in der Nähe der Spulen zusätzlich zu einer Änderung der Kopplung der Spulen. Dadurch dass die Spule oder die Spulen in einem Schwingkreis angeordnet sind, führt auch eine geringe Anregung zu hohen Oszillationsamplituden, bei welchen Änderungen leicht detektiert werden können. Es ist jedoch auch möglich, dass andere Faktoren wie Temperatureinflüsse oder Bauteilalterung zu einer Änderung der Amplitude führen. Somit können Metalldetektoren, welche großen Temperaturunterschieden ausgesetzt sind oder welche über einen langen Zeitraum verwendet werden, große Ungenauigkeiten bei der Detektion von metallischen Gegenständen aufweisen.

In US 4084135 A wird ein Metalldetektor mit einem Transmitter und einer Empfängerspule beschrieben. Die Empfängerspule ist mit einem Verstärker verbunden.

In DE 102010009576 A1 wird ein Näherungsschalter beschrieben. Dieser weist eine Sendespule, eine Referenzspule und zwei Empfangsspulen auf. Die Empfangsspulen sind als Differenzspule geschaltet.

In EP 2555019 A1 wird ein Näherungssensor mit einer Sendespule und einer Empfangsspule beschrieben. Die Sendespule ist mit einer Anregungseinrichtung und die Empfangsspule mit einer Auswerteeinrichtung verbunden.

In EP 2562565 A1 wird ein Metalldetektor mit einem Transmitter und zwei Empfängerspulen beschrieben. Der Transmitter weist eine Transmitterspule und eine Energieversorgung auf und die Empfängerspulen sind mit einem Prozessor verbunden.

In US 2016/290833 A1 wird ein Sensor mit einer Spule in einer Detektionseinheit beschrieben.

In EP 2493076 A1 wird ein induktiver Näherungssensor beschrieben.

Eine zu lösende Aufgabe besteht darin, einen Detektor zum Detektieren von elektrisch leitfähigem Material anzugeben, welcher effizient betrieben werden kann.

Die Aufgabe wird durch den Gegenstand des unabhängigen Patentanspruchs gelöst. Vorteilhafte Ausgestaltungen und Weiterbildungen sind in den Unteransprüchen angegeben.

Gemäß zumindest einer Ausführungsform des Detektors zum Detektieren von elektrisch leitfähigem Material, umfasst der Detektor mindestens einen Sender mit einer Senderspule und einer Versorgungsquelle. Bei der Versorgungsquelle kann es sich um eine Spannungsquelle oder um eine Stromquelle handeln. Die Senderspule kann ein elektrisch leitfähiges Material aufweisen. Die Senderspule kann elektrisch mit der Versorgungsquelle verbunden sein. Die Versorgungsquelle ist dazu ausgelegt, im Betrieb eine Wechselspannung oder einen Wechselstrom bereitzustellen. Die Amplitude und die Frequenz der Wechselspannung können vorgebbar sein.

Der Detektor umfasst weiter einen Empfänger mit einer Empfängerspule. Die Empfängerspule kann ein elektrisch leitfähiges Material aufweisen. Der Sender und der Empfänger können separat voneinander angeordnet sein. Das kann bedeuten, dass der Sender und der Empfänger nicht über beispielsweise ein Kabel oder eine andere elektrisch leitfähige Verbindung miteinander verbunden sind.

Der Detektor umfasst weiter eine Auswerteeinheit. Die Auswerteeinheit ist dazu ausgelegt, ein in der Empfängerspule induziertes Signal zu detektieren. Bei dem Signal kann es sich um eine elektrische Spannung oder einen elektrischen Strom handeln. Der Empfänger ist mit der Auswerteeinheit verbunden. Der Empfänger kann elektrisch mit der Auswerteeinheit verbunden sein. Bei der Auswerteeinheit kann es sich um eine Signal Auswerteeinheit handeln. Die Auswerteeinheit kann dazu ausgelegt sein, eine Spannung oder einen Strom zu messen. Beispielsweise kann die Auswerteeinheit einen ersten Eingang und einen zweiten Eingang aufweisen. Die Empfängerspule kann einen ersten Anschluss und einen zweiten Anschluss aufweisen, wobei der zweite Anschluss an der dem ersten Anschluss abgewandten Seite der Empfängerspule angeordnet ist. Jeder der Anschlüsse der Empfängerspule kann mit jeweils einem der Eingänge der Auswerteeinheit elektrisch verbunden sein. Die Auswerteeinheit kann dazu ausgelegt sein, die an der Empfängerspule anliegende Spannung zu messen. Die Auswerteeinheit kann weiter dazu ausgelegt sein den Wert der gemessenen Spannung an einem Ausgang der Auswerteeinheit bereitzustellen.

Der Empfänger ist als schwingkreisloser Empfänger eingerichtet. Das bedeutet, dass es sich bei dem Empfänger um einen schwingkreislosen Empfänger handelt. Weiter wird der Empfänger im Betrieb des Detektors nicht als Schwingkreis betrieben. Die Empfängerspule kann direkt mit der Auswerteeinheit elektrisch verbunden sein. Das kann bedeuten, dass jeder der Anschlüsse der Empfängerspule direkt mit jeweils einem der Eingänge der Auswerteeinheit elektrisch verbunden ist.

Dem hier beschriebenen Detektor liegt unter anderem die Idee zugrunde, dass elektrisch leitfähiges Material in der Umgebung des Detektors detektiert werden kann. Ist die Empfängerspule in einem Magnetfeld angeordnet, so kann bei einer Änderung des Magnetfeldes in der Empfängerspule eine Spannung induziert werden. Das Magnetfeld kann sich beispielsweise dadurch ändern, dass sich ein elektrisch leitfähiges Material im Magnetfeld bewegt. Der Detektor kann außerdem zur Detektion von ferromagnetischem Material verwendet werden, da sich das Magnetfeld ebenfalls dadurch ändern kann, dass sich ein ferromagnetisches Material im Magnetfeld bewegt. Die Auswerteeinheit ist dazu ausgelegt das in der Empfängerspule induzierte Signal, zum Beispiel eine Spannung, zu detektieren. Somit gibt eine Änderung der in der Empfängerspule induzierten Spannung an, dass sich ein elektrisch leitfähiges Material, ein elektrisch leitfähiger Gegenstand, ein ferromagnetisches Material oder ein ferromagnetischer Gegenstand im Magnetfeld bewegt oder sich dem Detektor nähert.

Da der Empfänger als schwingkreisloser Empfänger eingerichtet ist, weist der Empfänger bevorzugt keine Resonanzfrequenz auf. Bei einem Schwingkreis kann die Amplitude der in einer Spule des Schwingkreises induzierten Spannung sowohl von der induzierten Spannung als auch von anderen Parametern wie Temperatureinflüssen oder Bauteilalterung nicht-linear abhängen. Im Gegensatz dazu hängt die Amplitude der in der hier beschriebenen Empfängerspule induzierten Spannung lediglich von der Induktivität der Empfängerspule ab. Die Abhängigkeit der Amplitude der in der Empfängerspule induzierten Spannung von der Induktivität der Empfängerspule kann Wurzel-förmig sein. Die Induktivität der Empfängerspule hängt von der Geometrie der Empfängerspule und von Materialien, welche magnetisch oder elektrisch leitfähig sind, in der Umgebung der Empfängerspule ab. Da die Geometrie der Empfängerspule sich im Betrieb des Detektors in den meisten Fällen nicht oder nur geringfügig ändert, hängt die Amplitude der in der Empfängerspule induzierten Spannung lediglich von Materialien in der Umgebung der Empfängerspule ab.

Somit ermöglicht der hier beschriebene Detektor eine genauere Messung der in der Empfängerspule induzierten Spannung mit geringen Einflüssen oder ohne Einflüsse der Temperatur oder einer Bauteilalterung auf die Messung der induzierten Spannung. Ein Nachregeln von Parametern des Senders oder des Empfängers im Betrieb des Detektors ist nicht nötig.

Außerdem ist vorteilhafterweise keine exakte Abstimmung von Parametern eines Schwingkreises oder von zwei gekoppelten Schwingkreisen nötig, da es sich bei dem Empfänger um einen schwingkreislosen Empfänger handelt.

Es ist weiter möglich eine Empfängerspule mit einer möglichst hohen Induktivität zu verwenden. Je höher die Induktivität der Empfängerspule ist, desto größer ist eine in der Empfängerspule induzierte Spannung. Je größer die in der Empfängerspule induzierte Spannung ist, desto einfacher und genauer kann die induzierte Spannung von der Auswerteeinheit detektiert und gemessen werden. Die Güte der verwendeten Empfängerspule ist dabei nicht entscheidend für die Genauigkeit der Messung der induzierten Spannung, da die Empfängerspule nicht in einem Schwingkreis verwendet wird. Somit kann eine Empfängerspule mit einer möglichst hohen Induktivität ohne Rücksicht auf die Höhe der Güte der Empfängerspule verwendet werden. Vorteilhafterweise können daher beispielsweise Spulen, welche auf einer Leiterplatte angeordnet sind (sogenannte "printed circuit board (PCB) Spulen"), als Empfängerspule verwendet werden. Dabei sollte die Auswerteeinheit eine hohe Eingangsimpedanz aufweisen.

Der hier beschriebene Detektor kann beispielsweise als Raddetektor an Schienen zur Detektion von Rädern eines Zuges verwendet werden. Dabei kann der Detektor derart angeordnet werden, dass ein Rad eines Zuges sich in einem Magnetfeld bewegt, wenn der Zug die Position des Detektors passiert, und dass sich durch die Bewegung des Rades im Magnetfeld eine in der Empfängerspule induzierte Spannung ändert. Die in der Empfängerspule induzierte Spannung und deren Änderung kann von der Auswerteeinheit detektiert werden. Somit kann die Auswerteeinheit detektieren, dass ein Zug die Position des Detektors passiert.

Gemäß zumindest einer Ausführungsform des Detektors, wird im Betrieb die von der Versorgungsquelle bereitgestellte Wechselspannung oder der von der Versorgungsquelle bereitgestellte Wechselstrom in die Senderspule eingekoppelt. Die Versorgungsquelle kann einen ersten Ausgang und einen zweiten Ausgang aufweisen. Zwischen dem ersten Ausgang und dem zweiten Ausgang kann die bereitgestellte Wechselspannung anliegen. Die Senderspule kann einen ersten Anschluss und einen zweiten Anschluss aufweisen, wobei der zweite Anschluss an der dem ersten Anschluss abgewandten Seite der Senderspule angeordnet ist. Jeder der Anschlüsse der Senderspule kann mit jeweils einem Ausgang der Versorgungsquelle elektrisch verbunden sein. Somit wird die im Betrieb von der Versorgungsquelle bereitgestellte Wechselspannung oder der von der Versorgungsquelle bereitgestellte Wechselstrom in die Senderspule eingekoppelt.

Gemäß zumindest einer Ausführungsform des Detektors, erzeugt die Senderspule durch das Anlegen einer Spannung oder eines Stroms an die Senderspule ein Sendermagnetfeld. Beispielsweise kann die Senderspule durch das Anlegen der von der Versorgungsquelle bereitgestellten Wechselspannung an die Senderspule ein Sendermagnetfeld erzeugen. Das Sendermagnetfeld kann von der Frequenz der Wechselspannung und Parametern der Senderspule abhängen. Das Sendermagnetfeld kann als Magnetfeld zur Detektion von metallischen oder ferromagnetischen Gegenständen im Sendermagnetfeld verwendet werden.

Gemäß zumindest einer Ausführungsform des Detektors, sind die Senderspule und die Empfängerspule derart angeordnet, dass ein von der Senderspule erzeugtes Sendermagnetfeld ein Signal in der Empfängerspule induziert. Bei dem Signal kann es sich um eine elektrische Spannung oder einen elektrischen Strom handeln. Das kann bedeuten, dass die Empfängerspule im Sendermagnetfeld angeordnet ist. Es ist weiter möglich, dass die Senderspule und die Empfängerspule derart angeordnet sind, dass das von der Senderspule erzeugte Sendermagnetfeld ein Signal in der Empfängerspule induziert, welches von der Auswerteeinheit detektiert werden kann. Somit kann die Empfängerspule in der Umgebung der Senderspule angeordnet sein. Beispielsweise beträgt die Entfernung zwischen der Empfängerspule und der Senderspule weniger als 1 m oder weniger als 20 cm. Die Senderspule und die Empfängerspule können derart angeordnet sein, dass sie miteinander gekoppelt sind. Bei einer Änderung des Sendermagnetfeldes ändert sich somit auch das in der Empfängerspule induzierte Signal. Dies ermöglicht die Detektion von elektrisch leitfähigem oder ferromagnetischem Material, welches sich im Sendermagnetfeld befindet.

Gemäß zumindest einer Ausführungsform des Detektors, beträgt die Kopplung zwischen der Senderspule und der Empfängerspule weniger als 5 %. Die Kopplung zwischen der Senderspule und der Empfängerspule kann weniger als 1 % betragen. Je größer die Kopplung zwischen der Senderspule und der Empfängerspule ist, desto größer ist die in der Empfängerspule induzierte Spannung. Bei einer geringen Kopplung zwischen der Senderspule und der Empfängerspule wirken sich Änderungen der Kopplung zwischen der Senderspule und der Empfängerspule aufgrund von einer Bewegung von elektrisch leitfähigem und/oder ferromagnetischen Material im Sendermagnetfeld in Relation zur Kopplung ohne Beeinflussung stärker auf die in der Empfängerspule induzierte Spannung aus als bei einer größeren Kopplung.

Gemäß zumindest einer Ausführungsform des Detektors, hängt das in der Empfängerspule induzierte Signal von elektrisch leitfähigem Material in der Umgebung der Empfängerspule ab. Das Sendermagnetfeld hängt von elektrisch leitfähigem Material im Sendermagnetfeld ab. Beispielsweise ändert sich das Sendermagnetfeld, wenn sich elektrisch leitfähiges Material im Sendermagnetfeld bewegt oder wenn sich elektrisch leitfähiges Material in das Sendermagnetfeld hinein bewegt. Durch eine Änderung des Sendermagnetfeldes ändert sich ebenfalls das in der Empfängerspule induzierte Signal. Somit hängt das in der Empfängerspule induzierte Signal davon ab, ob sich elektrisch leitfähiges Material im Sendermagnetfeld und damit in der Umgebung der Empfängerspule bewegt. Dies gilt auch für ferromagnetisches Material.

Daher kann der Detektor zum Detektieren von elektrisch leitfähigem Material verwendet werden. Elektrisch leitfähiges Material kann im Bereich des Sendermagnetfeldes detektiert werden. Bewegt sich ein elektrisch leitfähiger Gegenstand, wie beispielsweise ein Rad eines Zuges, in das Sendermagnetfeld, so ändert sich das in der Empfängerspule induzierte Signal. Die Senderspule und der elektrisch leitfähige Gegenstand sind in diesem Fall induktiv gekoppelt. Die Änderung des in der Empfängerspule induzierten Signals kann von der Auswerteeinheit detektiert werden und zeigt somit die Anwesenheit eines elektrisch leitfähigen Gegenstandes im Sendermagnetfeld an. Der Detektor kann beispielsweise an einer Schiene angeordnet sein und dazu ausgelegt sein einen Zug an der Position des Detektors zu detektieren, indem die Anwesenheit eines Rades eines Zuges detektiert wird, wobei das Rad ein elektrisch leitfähiges oder ein ferromagnetisches Material aufweist.

Gemäß zumindest einer Ausführungsform des Detektors, ist die Auswerteeinheit dazu ausgelegt, ein Ausgangssignal bereitzustellen, das von einer Änderung des in der Empfängerspule induzierten Signals abhängt. Das Ausgangssignal kann am Ausgang der Auswerteeinheit bereitgestellt werden. Das in der Empfängerspule induzierte Signal kann sich ändern, wenn sich ein elektrisch leitfähiges Material oder ein ferromagnetisches Material im Sendermagnetfeld bewegt. Somit kann das Ausgangssignal die Information enthalten, dass ein elektrisch leitfähiger oder einen ferromagnetischer Gegenstand im Sendermagnetfeld detektiert wurde. Der Detektor kann daher zum Detektieren von elektrisch leitfähigem oder ferromagnetischem Material verwendet werden.

Gemäß zumindest einer Ausführungsform des Detektors, ist die Auswerteeinheit dazu ausgelegt, die Amplitude und/oder die Phase des in der Empfängerspule induzierten Signals zu bestimmen. Das kann bedeuten, dass die Auswerteeinheit dazu ausgelegt ist, den Wert der in der Empfängerspule induzierten Spannung oder des in der Empfängerspule induzierten Stroms zu bestimmen. Die Auswerteeinheit kann dazu ausgelegt sein, die Amplitude und/oder die Phase des in der Empfängerspule induzierten Signals kontinuierlich oder in vorgebbaren Zeitabständen zu bestimmen. Somit kann eine Änderung des in der Empfängerspule induzierten Signals detektiert werden.

Gemäß zumindest einer Ausführungsform des Detektors, ist die Auswerteeinheit dazu ausgelegt, die Phase des in der Empfängerspule induzierten Signals zu bestimmen. Aus einem Vergleich der Phase der in der Empfängerspule induzierten Spannung mit der Phase der an der Senderspule anliegenden Spannung kann auf Verluste, wie beispielsweise Wirbelstromverluste, im Sendermagnetfeld oder externe Störungen rückgeschlossen werden.

Gemäß zumindest einer Ausführungsform des Detektors, weist der Detektor einen weiteren Sender mit einer weiteren Senderspule und einer weiteren Versorgungsquelle auf. Der weitere Sender kann den gleichen Aufbau wie der Sender haben. Der Sender und der weitere Sender können beabstandet zueinander angeordnet sein. Der Sender und der weitere Sender können etwa in der gleichen Entfernung vom Empfänger angeordnet sein. Bei der weiteren Versorgungsquelle kann es sich um eine Spannungsquelle oder um eine Stromquelle handeln.

Gemäß zumindest einer Ausführungsform des Detektors, ist die weitere Versorgungsquelle dazu ausgelegt im Betrieb eine Wechselspannung oder einen Wechselstrom bereitzustellen, deren oder dessen Frequenz verschieden von der Frequenz der von der Versorgungsquelle bereitgestellten Wechselspannung oder des von der Versorgungsquelle bereitgestellten Wechselstroms ist. Die von der weiteren Versorgungsquelle im Betrieb bereitgestellte Wechselspannung oder der Wechselstrom kann eine größere Frequenz oder eine kleinere Frequenz als die von der Versorgungsquelle im Betrieb bereitgestellte Wechselspannung oder der von der Versorgungsquelle im Betrieb bereitgestellte Wechselstrom aufweisen. Durch das Einkoppeln der von der weiteren Versorgungsquelle bereitgestellten Wechselspannung oder des Wechselstroms in die weitere Senderspule wird ein weiteres Sendermagnetfeld erzeugt. Die weitere Senderspule und die Empfängerspule können derart angeordnet sein, dass ein von der weiteren Senderspule erzeugtes weiteres Sendermagnetfeld eine Spannung in der Empfängerspule induziert. Somit ermöglicht die weitere Versorgungsquelle die Detektion von elektrisch leitfähigem Material mit einer weiteren Frequenz der Wechselspannung, durch welche das weitere Sendermagnetfeld erzeugt wird. Durch die Verwendung von zwei Sendern mit unterschiedlichen Frequenzen können Störungen bei gewissen Frequenzen bestimmt und damit unerwünschte Frequenzbereiche vermieden werden.

Der Sender und der weitere Sender können gleichzeitig betrieben werden. Daher kann elektrisch leitfähiges Material gleichzeitig bei verschiedenen Frequenzen detektiert werden. Dies ist zum Beispiel vorteilhaft, falls in einem Frequenzbereich eine externe oder interne Störfrequenz auftritt. In diesem Fall kann der jeweils andere Sender verwendet werden, bei welchem die Störfrequenz nicht im Bereich der Frequenz der bereitgestellten Wechselspannung liegt. Es ist weiter möglich, die Störung durch einen Vergleich der beiden in der Empfängerspule induzierten Spannungen festzustellen. Somit kann der Detektor verlässlicher betrieben werden und die Genauigkeit kann verbessert werden.

Gemäß zumindest einer Ausführungsform des Detektors, weist der Sender einen Kondensator auf, welcher mit der Senderspule einen Schwingkreis bildet. Der Kondensator kann elektrisch parallel zur Senderspule geschaltet sein. Der Schwingkreis kann eine Resonanzfrequenz aufweisen. Es ist weiter möglich, dass der Schwingkreis mindestens zwei Resonanzfrequenzen aufweist. Die Resonanzfrequenz oder die Resonanzfrequenzen des Schwingkreises können einstellbar sein. Die von der Versorgungsquelle bereitgestellte Wechselspannung kann gleich oder ungefähr gleich der Resonanzfrequenz oder einer der Resonanzfrequenzen des Schwingkreises sein. Je näher die Frequenz der bereitgestellten Wechselspannung der Resonanzfrequenz des Schwingkreises ist, desto größer ist die Stromstärke in der Senderspule. Wenn die Frequenz der von der Versorgungsquelle bereitgestellten Wechselspannung gleich oder ungefähr gleich der Resonanzfrequenz oder einer der Resonanzfrequenzen des Schwingkreises ist, kann somit der Schwingkreis effizient angeregt werden. Je größer die Stromstärke in der Senderspule ist, desto größer ist die magnetische Feldstärke des Sendermagnetfeldes. Eine große magnetische Feldstärke des Sendermagnetfeldes kann die Genauigkeit der Detektion des in der Empfängerspule induzierten Signals verbessern.

Der Empfänger weist erfindungsgemäß eine weitere Empfängerspule auf. Die weitere Empfängerspule weist erfindungsgemäβ den gleichen Aufbau wie die Empfängerspule auf. Die weitere Empfängerspule kann einen ersten Anschluss und einen zweiten Anschluss aufweisen, wobei der zweite Anschluss an der dem ersten Anschluss abgewandten Seite der weiteren Empfängerspule angeordnet ist. Die Auswerteeinheit kann einen dritten Eingang und einen vierten Eingang aufweisen. Der erste Anschluss der weiteren Empfängerspule kann elektrisch mit dem dritten Eingang der Auswerteeinheit verbunden sein und der zweite Anschluss der weiteren Empfängerspule kann elektrisch mit dem vierten Eingang der Auswerteeinheit verbunden sein. Alternativ ist es auch möglich, dass der erste Anschluss der weiteren Empfängerspule elektrisch mit dem vierten Eingang der Auswerteeinheit verbunden ist und der zweite Anschluss der weiteren Empfängerspule elektrisch mit dem dritten Eingang der Auswerteeinheit verbunden ist.

Gemäß zumindest einer Ausführungsform des Detektors, weisen die Empfängerspule und die weitere Empfängerspule den gleichen Aufbau auf. Beispielsweise können die Empfängerspule und die weitere Empfängerspule die gleiche Windungszahl aufweisen. Es ist weiter möglich, dass die Empfängerspule und die weitere Empfängerspule die gleiche Größe und den gleichen Querschnitt aufweisen. Die Empfängerspule und die weitere Empfängerspule können mit dem gleichen Material gebildet sein.

Die Empfängerspule und die weitere Empfängerspule weisen erfindungsgemäβ den gleichen Wicklungssinn auf. Werden die Signale der Empfängerspule und der weiteren Empfängerspule voneinander abgezogen, können Gleichtaktstörungen unterdrückt werden.

Die Auswerteeinheit weist erfindungsgemäβ einen Differenzverstärker auf. Der Differenzverstärker kann einen ersten Eingang und einen zweiten Eingang aufweisen. Einer der Anschlüsse der Empfängerspule kann elektrisch mit dem ersten Eingang des Differenzverstärkers verbunden sein. Einer der Anschlüsse der weiteren Empfängerspule kann elektrisch mit dem zweiten Eingang des Differenzverstärkers verbunden sein. Es ist weiter möglich, dass einer der Anschlüsse der Empfängerspule elektrisch mit dem zweiten Eingang des Differenzverstärkers verbunden ist und einer der Anschlüsse der weiteren Empfängerspule elektrisch mit dem ersten Eingang des Differenzverstärkers verbunden ist. Der Differenzverstärker kann dazu ausgelegt sein zwei an den Eingängen erhaltene Signale voneinander zu subtrahieren.

Ist der Empfänger in einem homogenen elektrischen Störfeld angeordnet, so werden in die Empfängerspule und die weitere Empfängerspule die gleichen Spannungen kapazitiv gekoppelt, da die Empfängerspule und die weitere Empfängerspule den gleichen Aufbau aufweisen. Im Differenzverstärker werden die eingekoppelten Spannungen voneinander abgezogen. Da in die Empfängerspule und in die weitere Empfängerspule die gleichen Spannungen kapazitiv eingekoppelt werden, kompensieren sich die eingekoppelten Spannungen. Dies ist insbesondere der Fall, wenn die Empfängerspule und die weitere Empfängerspule den gleichen Aufbau und den gleichen Wicklungssinn aufweisen. Somit kann durch die Verwendung des Differenzverstärkers die kapazitive Einkopplung durch homogene elektrische Störfelder verringert oder verhindert werden.

Ist der Empfänger in einem homogenen magnetischen Störfeld angeordnet, so wird in der Empfängerspule und in der weiteren Empfängerspule die gleiche Spannung induziert, da die Empfängerspule und die weitere Empfängerspule den gleichen Aufbau und den gleichen Wicklungssinn aufweisen. Im Differenzverstärker können diese induzierten Spannungen voneinander abgezogen werden. Da in die Empfängerspule und in der weiteren Empfängerspule die gleiche Spannung induziert wird, kompensieren sich die induzierten Spannungen. Dies ist insbesondere der Fall, wenn die Empfängerspule und die weitere Empfängerspule den gleichen Aufbau und den gleichen Wicklungssinn aufweisen. Somit können durch die Verwendung des Differenzverstärkers induktive Einkopplungen homogener magnetischer Störfelder unterdrückt oder verhindert werden.

Der Differenzverstärker kann einen Bandpassfilter aufweisen. Dabei kann die Frequenz der Wechselspannung, welche an der Senderspule anliegt, eine Durchlassfrequenz des Bandpassfilters sein. Somit werden lediglich Störfelder jedoch nicht das zu detektierende Signal unterdrückt.

Je größer die Gleichtaktunterdrückung des Differenzverstärkers ist und je größer die Gleichartigkeit des Aufbaus ist, desto effizienter können Einflüsse durch homogene elektrische oder magnetische Störfelder unterdrückt werden.

Gemäß zumindest einer Ausführungsform des Detektors, ist der Differenzverstärker dazu ausgelegt ein Ausgangssignal bereitzustellen, wobei das Ausgangssignal von der Amplitude und der Phase des in der Empfängerspule induzierten Signals und von der Amplitude und der Phase des in der weiteren Empfängerspule induzierten Signals abhängt. Das kann bedeuten, dass nach dem Abzug von Einflüssen eventueller Störfelder, das Ausgangssignal von der Amplitude und der Phase des in der Empfängerspule induzierten Signals und von der Amplitude und der Phase des in der weiteren Empfängerspule induzierten Signals abhängt.

Die Empfängerspule und die weitere Empfängerspule sind erfindungsgemäß jeweils an einem ihrer Enden mit einem Differenzverstärker verbunden und an ihrem anderen Ende mit einer Spannungsversorgung verbunden. Dies ermöglicht die Unterdrückung von Einflüssen durch homogene elektrische oder magnetische Störfelder.

Ein Regler ist erfindungsgemäß mit dem Differenzverstärker verbunden. Der Regler kann dazu ausgelegt sein die Spannungsversorgungen, mit welchen die Empfängerspule und die weitere Empfängerspule verbunden sind, derart anzusteuern, dass das Ausgangssignal des Differenzverstärkers immer Null ergibt. Dazu wird im Regler ein Regelungssignal bestimmt. Das Regelungssignal hängt von dem vom Empfänger zu detektierenden Signal ab. Somit kann aus dem Regelungssignal das zu detektierende Signal bestimmt werden.

Gemäß zumindest einer Ausführungsform des Detektors, weist die Empfängerspule die Form einer Acht mit zwei Spulenhälften auf. Das bedeutet, bei der Empfängerspule kann es sich um eine Achterspule handeln. Ist eine solche Spule in einem homogenen magnetischen Störfeld angeordnet, so wird in beiden Spulenhälften die gleiche Spannung mit unterschiedlichem Vorzeichen induziert. Somit kompensieren sich vorteilhafterweise die beiden induzierten Spannungen.

Im Folgenden wird der hier beschriebene Detektor in Verbindung mit Ausführungsbeispielen und den dazugehörigen Figuren näher erläutert.

Die Figuren 1 und 2 zeigen Beispiele eines Detektors zum Detektieren von elektrisch leitfähigem Material.

In Figur 3 ist die Übertragungsfunktion eines Empfängers gezeigt.

In Figur 4 ist ein Ausführungsbeispiel eines Empfängers mit einer Auswerteeinheit gezeigt.

Die Figuren 5, 6, 7, 8, 9, 10, 11, 12 und 13 zeigen Ausführungsbeispiele der Empfängerspule und der weiteren Empfängerspule.

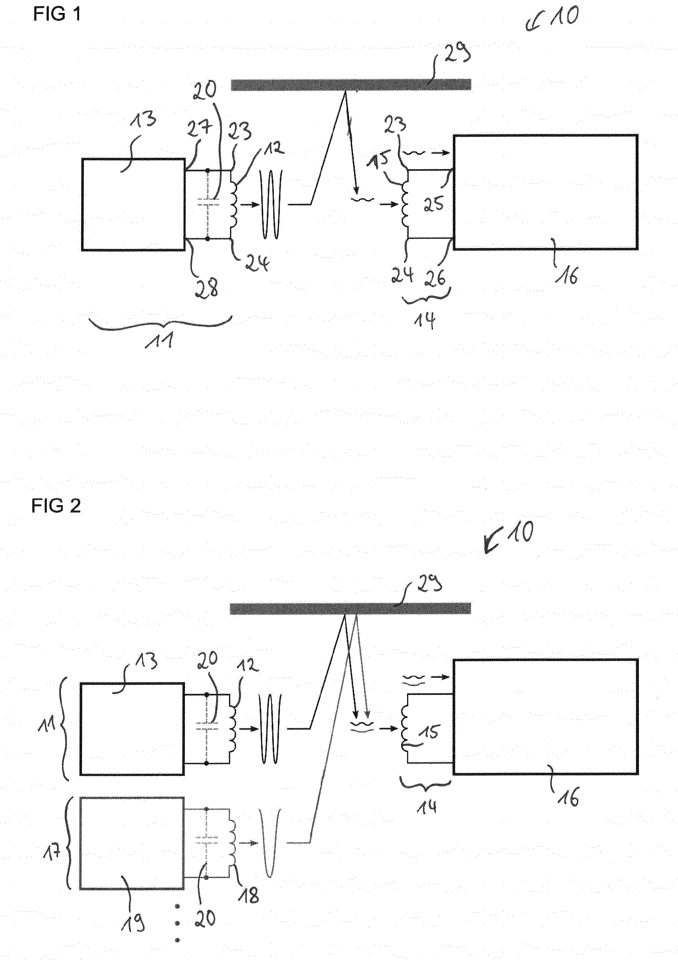

In Figur 1 ist schematisch ein Beispiel eines Detektors 10 zum Detektieren von elektrisch leitfähigem Material gezeigt, welches kein Ausführungsbeispiel ist. Der Detektor 10 weist einen Sender 11 mit einer Senderspule 12 und einer Versorgungsquelle 13 auf. Bei der Versorgungsquelle 13 kann es sich um eine Spannungsquelle oder um eine Stromquelle handeln. Die Senderspule 12 ist elektrisch mit der Versorgungsquelle 13 verbunden. Die Versorgungsquelle 13 weist einen ersten Ausgang 27 und einen zweiten Ausgang 28 auf. Die Senderspule 12 weist einen ersten Anschluss 23 und einen zweiten Anschluss 24 auf, wobei der zweite Anschluss 24 an der dem ersten Anschluss 23 abgewandten Seite der Senderspule 12 angeordnet ist. Der erste Anschluss 23 der Senderspule 12 ist elektrisch mit dem ersten Ausgang 27 der Versorgungsquelle 13 verbunden. Der zweite Anschluss 24 der Senderspule 12 ist elektrisch mit dem zweiten Ausgang 28 der Versorgungsquelle 13 verbunden. Die Versorgungsquelle 13 ist dazu ausgelegt im Betrieb eine Wechselspannung oder einen Wechselstrom bereitzustellen. Die im Betrieb von der Versorgungsquelle 13 bereitgestellte Wechselspannung oder der von der Versorgungsquelle 13 bereitgestellte Wechselstrom wird in die Senderspule 12 eingekoppelt. Die Senderspule 12 erzeugt durch das Anlegen der Wechselspannung an die Senderspule 12 ein Sendermagnetfeld.

Optional weist der Sender 11 einen Kondensator 20 auf, welcher mit der Senderspule 12 einen Schwingkreis bildet. Da der Kondensator 20 optional ist, ist dieser in Figur 1 gestrichelt dargestellt. Der Kondensator 20 ist elektrisch parallel zur Senderspule 12 geschaltet.

Benachbart zur Senderspule 12 ist schematisch dargestellt, dass das von der Senderspule 12 erzeugte Sendermagnetfeld eine zeitlich veränderliche magnetische Feldstärke aufweist. Außerdem ist schematisch ein elektrisch leitfähiger oder ferromagnetischer Gegenstand 29, welcher sich im Bereich des Sendermagnetfeldes befindet, dargestellt. In diesem Fall sind die Senderspule 12 und der Gegenstand 29 induktiv gekoppelt.

Der Detektor 10 weist weiter einen Empfänger 14 mit einer Empfängerspule 15 auf. Außerdem weist der Detektor 10 eine Auswerteeinheit 16 auf. Der Empfänger 14 ist mit der Auswerteeinheit 16 verbunden und der Empfänger 14 ist als schwingkreisloser Empfänger eingerichtet. Die Empfängerspule 15 weist einen ersten Anschluss 23 und einen zweiten Anschluss 24 auf, wobei der zweite Anschluss 24 an der dem ersten Anschluss 23 abgewandten Seite der Empfängerspule 15 angeordnet ist. Die Auswerteeinheit 16 weist einen ersten Eingang 25 und einen zweiten Eingang 26 auf. Der erste Anschluss 23 der Empfängerspule 15 ist elektrisch mit dem ersten Eingang 25 der Auswerteeinheit 16 verbunden. Der zweite Anschluss 24 der Empfängerspule 15 ist elektrisch mit dem zweiten Eingang 26 der Auswerteeinheit 16 verbunden. Die Auswerteeinheit 16 ist dazu ausgelegt ein in der Empfängerspule 15 induziertes Signal, beispielsweise eine elektrische Spannung oder einen elektrischen Strom, zu detektieren.

Wie in Figur 1 gezeigt, sind die Senderspule 12 und die Empfängerspule 15 derart angeordnet, dass das von der Senderspule 12 erzeugte Sendermagnetfeld eine Spannung in der Empfängerspule 15 induziert. Dabei hängt die in der Empfängerspule 15 induzierte Spannung davon ab, ob sich ein elektrisch leitfähiges Material oder ein ferromagnetische Material im Bereich des Sendermagnetfeldes befindet oder bewegt. Es ist schematisch dargestellt, dass in der Empfängerspule 15 eine Wechselspannung induziert wird, bei welcher die Amplitude wesentlich geringer ist als die Amplitude der von der Versorgungsquelle 13 bereitgestellten Wechselspannung. Die Kopplung der Senderspule 12 mit der Empfängerspule 15 kann beispielsweise weniger als 5 % betragen. Somit sollte die Auswerteeinheit 16 empfindlich genug sein, um kleine Spannungen zu detektieren.

Die Auswerteeinheit 16 ist dazu ausgelegt, die Amplitude und/oder die Phase der in der Empfängerspule 15 induzierten Spannung zu bestimmen. Außerdem kann die Auswerteeinheit 16 dazu ausgelegt sein ein Ausgangssignal bereitzustellen, das von einer Änderung der in der Empfängerspule 15 induzierten Spannung abhängt. Da der Empfänger 14 als schwingkreisloser Empfänger eingerichtet ist, hängen die Amplitude und die Phase der in der Empfängerspule 15 induzierten Spannung lediglich von der Induktivität der Empfängerspule 15 ab. Im Gegensatz dazu können bei einem Schwingkreis Temperaturänderungen oder Bauteilalterung einen Einfluss auf die in einer Spule induzierte Spannung haben. Vorteilhafterweise hängen somit für den hier beschriebenen Detektor 10 die Amplitude und die Phase der in der Empfängerspule 15 induzierten Spannung nur geringfügig oder vernachlässigbar von Temperaturänderungen oder Bauteilalterung und hauptsächlich von der zu messenden Amplitude und Phase der in der Empfängerspule 15 induzierten Spannung ab.

In Figur 2 ist ein weiteres Beispiel des Detektors 10 gezeigt. Zusätzlich zu dem in Figur 1 gezeigten Aufbau weist der Detektor 10 einen weiteren Sender 17 mit einer weiteren Senderspule 18 und einer weiteren Versorgungsquelle 19 auf. Der weitere Sender 17 weist den gleichen Aufbau wie der Sender 11 auf. Der Sender 11 und der weitere Sender 17 unterscheiden sich dadurch, dass die weitere Versorgungsquelle 19 dazu ausgelegt ist im Betrieb eine Wechselspannung oder einen Wechselstrom bereitzustellen, deren oder dessen Frequenz verschieden von der Frequenz der von der Versorgungsquelle 13 des Senders 11 bereitgestellten Wechselspannung oder des von der Versorgungsquelle 13 bereitgestellten Wechselstroms ist. In Figur 2 ist schematisch dargestellt, dass die von der weiteren Versorgungsquelle 19 bereitgestellte Wechselspannung eine kleinere Frequenz als die von der Versorgungsquelle 13 bereitgestellte Wechselspannung aufweist. Somit wird auch durch das von der weiteren Senderspule 18 erzeugte Sendermagnetfeld eine Spannung in der Empfängerspule 15 induziert und von der Auswerteeinheit 16 detektiert.

Die Punkte unterhalb des weiteren Senders 17 deuten an, dass der Detektor 10 weitere Sender 17 aufweisen kann.

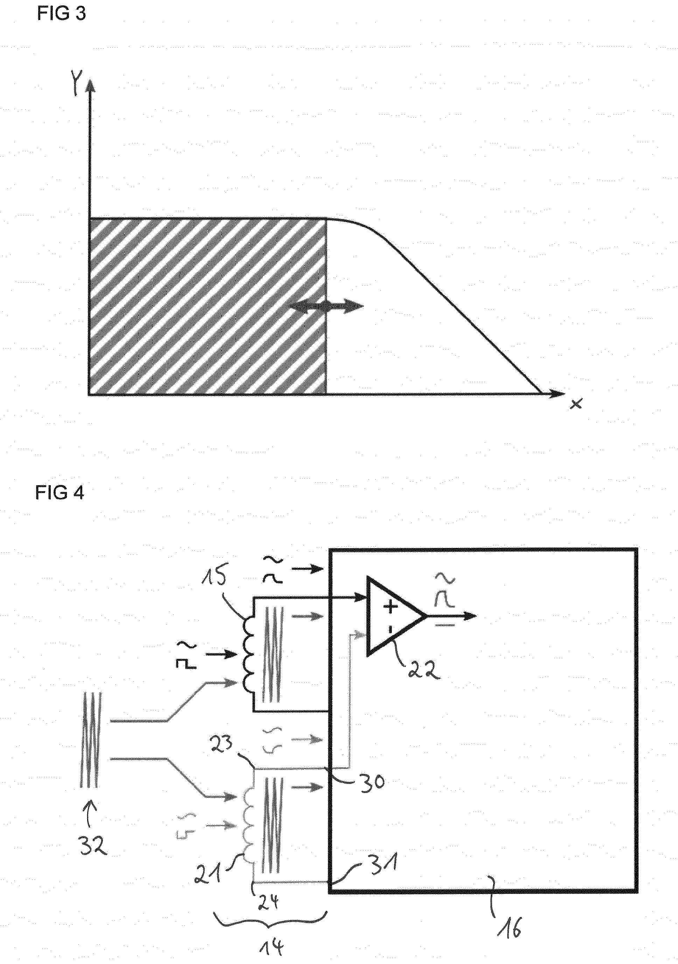

In Figur 3 ist die Übertragungsfunktion des Empfängers 14 gezeigt. Auf der x-Achse ist die Frequenz des in der Empfängerspule 15 induzierten Signals in willkürlichen Einheiten logarithmisch aufgetragen. Auf der y-Achse ist die Amplitude des in der Empfängerspule 15 induzierten Signals logarithmisch aufgetragen. Bevorzugt werden Frequenzen im schraffiert markierten Bereich verwendet, um die Amplitude des in der Empfängerspule 15 induzierten Signals zu bestimmen. In diesem Bereich hängt das in der Empfängerspule 15 induzierte Signal von der Induktivität der Empfängerspule 15 ab. Bei dem induzierten Signal kann es sich um eine elektrische Spannung handeln.

In Figur 4 ist ein Ausführungsbeispiel des Empfängers 14 gezeigt. Der Empfänger 14 weist die Empfängerspule 15 und eine weitere Empfängerspule 21 auf. Die Empfängerspule 15 und die weitere Empfängerspule 21 weisen den gleichen Aufbau und den gleichen Wicklungssinn auf. Ähnlich wie die Empfängerspule 15 weist die weitere Empfängerspule 21 einen ersten Anschluss 23 und einen zweiten Anschluss 24 auf, wobei der zweite Anschluss 24 an der dem ersten Anschluss 23 abgewandten Seite der weiteren Empfängerspule 21 angeordnet ist. Die Auswerteeinheit 16 weist weiter einen dritten Eingang 30 und einen vierten Eingang 31 auf. Der erste Anschluss 23 der weiteren Empfängerspule 21 ist elektrisch mit dem dritten Eingang 30 verbunden und der zweite Anschluss 24 der weiteren Empfängerspule 21 ist elektrisch mit dem vierten Eingang 31 verbunden. Außerdem weist die Auswerteeinheit 16 einen Differenzverstärker 22 auf.

In Figur 4 ist schematisch dargestellt, dass in der Umgebung des Empfängers 14 ein homogenes Störsignal 32 auftreten kann. Das homogene Störsignal 32 kann beispielsweise aufgrund eines homogenen elektrischen oder magnetischen Störfeldes auftreten. Bei einem homogenen elektrischen Störfeld wird in die Empfängerspule 15 und in die weitere Empfängerspule 21 die gleiche Spannung eingekoppelt, da die Empfängerspule 15 und die weitere Empfängerspule 21 den gleichen Aufbau aufweisen. Bei einem homogenen magnetischen Störfeld wird in der Empfängerspule 15 und in der weiteren Empfängerspule 21 die gleiche Spannung induziert, da die Empfängerspule 15 und die weitere Empfängerspule 21 den gleichen Aufbau und den gleichen Wicklungssinn aufweisen. Im Differenzverstärker 22 werden die eingekoppelten oder induzierten Spannungen voneinander abgezogen. Somit kompensieren sich die eingekoppelten oder induzierten Spannungen. Der Differenzverstärker 22 ist weiter dazu ausgelegt ein Ausgangssignal bereitzustellen, wobei das Ausgangssignal von der Amplitude der in der Empfängerspule 15 induzierten Spannung und von der Amplitude der in der weiteren Empfängerspule 21 induzierten Spannung abhängt. Vorteilhafterweise wird durch die Verwendung des Differenzverstärkers 22 die kapazitive beziehungsweise induktive Einkopplung durch Störfelder verringert oder verhindert.

Die von der Bewegung eines elektrisch leitfähigen oder ferromagnetischen Materials in der Empfängerspule 15 und der weiteren Empfängerspule 21 induzierte Spannung kompensiert sich vorteilhafterweise nicht. Die Empfängerspule 15 und die weitere Empfängerspule 21 sind derart im Sendermagnetfeld angeordnet, dass die durch eine Änderung des Sendermagnetfeldes in der Empfängerspule 15 und der weiteren Empfängerspule 21 induzierten Spannungen sich nicht kompensieren. Dazu sind die Empfängerspule 15 und die weitere Empfängerspule 21 beispielsweise nebeneinander angeordnet. Das Sendermagnetfeld kann inhomogen sein, so dass sich die in der Empfängerspule 15 und der weiteren Empfängerspule 21 induzierten Spannungen nicht kompensieren.

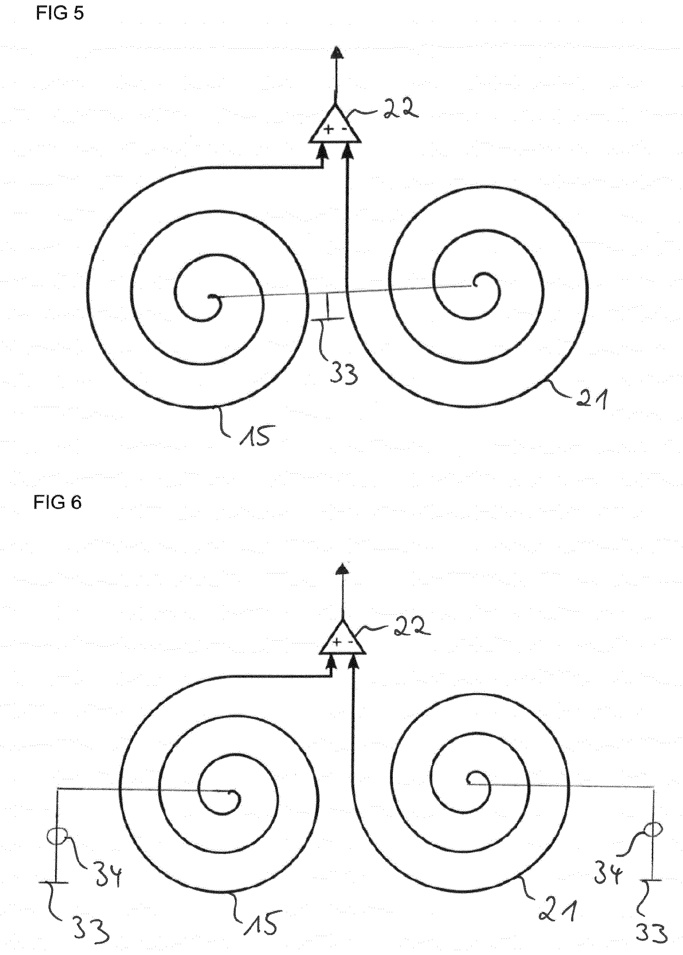

In Figur 5 ist ein Ausführungsbeispiel der Empfängerspule 15 mit der weiteren Empfängerspule 21 gezeigt. Die Empfängerspule 15 und die weitere Empfängerspule 21 weisen den gleichen Aufbau und den gleichen Wicklungssinn auf. Außerdem sind die Empfängerspule 15 und die weitere Empfängerspule 21 beide mit dem Differenzverstärker 22 verbunden. Die jeweils anderen Enden der Empfängerspule 15 und der weiteren Empfängerspule 21 sind mit einem Bezugspotenzial 33 verbunden. Bei dem Bezugspotenzial 33 handelt es sich beispielsweise um eine Erdung. Das bedeutet, die Empfängerspule 15 ist an einem ihrer Enden mit dem Differenzverstärker 22 verbunden und an ihrem anderen Ende mit dem Bezugspotenzial 33. Die weitere Empfängerspule 21 ist an einem ihrer Enden mit dem Differenzverstärker 22 verbunden und an ihrem anderen Ende mit dem Bezugspotenzial 33. Die Empfängerspule 21 ist an ihrem Ende, das mit dem Bezugspotenzial 33 verbunden ist, mit dem Ende der weiteren Empfängerspule 21 verbunden, das ebenfalls mit dem Bezugspotenzial 33 verbunden ist. Der Differenzverstärker 22 ist dazu ausgelegt die zwei erhaltenen Spannungen voneinander zu subtrahieren. Die Empfängerspule 15 und die weitere Empfängerspule 21 sind im Sendermagnetfeld nebeneinander angeordnet.

In Figur 6 ist ein weiteres Ausführungsbeispiel der Empfängerspule 15 mit der weiteren Empfängerspule 21 gezeigt. Die Empfängerspule 15 und die weitere Empfängerspule 21 weisen den in Figur 5 gezeigten Aufbau auf und sind wie im Ausführungsbeispiel in Figur 5 mit dem Differenzverstärker 22 verbunden. Die jeweils anderen Enden der Empfängerspule 15 und der weiteren Empfängerspule 21 sind jeweils mit einer Spannungsquelle 34 verbunden. Die Spannungsquellen 34 sind jeweils mit einem Bezugspotenzial 33 verbunden. Der Empfänger 14 kann derart betrieben werden, dass die zwei Spannungsquellen 34 jeweils die gleiche Gleichspannung bereitstellen und die Empfängerspule 15 und die weitere Empfängerspule 21 jeweils mit dieser versorgen. Alternativ ist es möglich, dass die Enden der Empfängerspule 15 und der weiteren Empfängerspule 21, die nicht mit dem Differenzverstärker 22 verbunden sind, mit nur einer gemeinsamen Spannungsquelle 34 verbunden sind. Der Empfänger 14 wird derart betrieben, dass die zwei Spannungsquellen 34 jeweils eine Wechselspannung bereitstellen und die Empfängerspule 15 und die weitere Empfängerspule 21 jeweils mit dieser versorgen. Die Frequenz dieser Wechselspannung entspricht der Frequenz der Wechselspannung, welche an der Senderspule 12 anliegt. Auf diese Art und Weise können geringfügige Unterschiede zwischen der Empfängerspule 15 und der weiteren Empfängerspule 21 kompensiert werden.

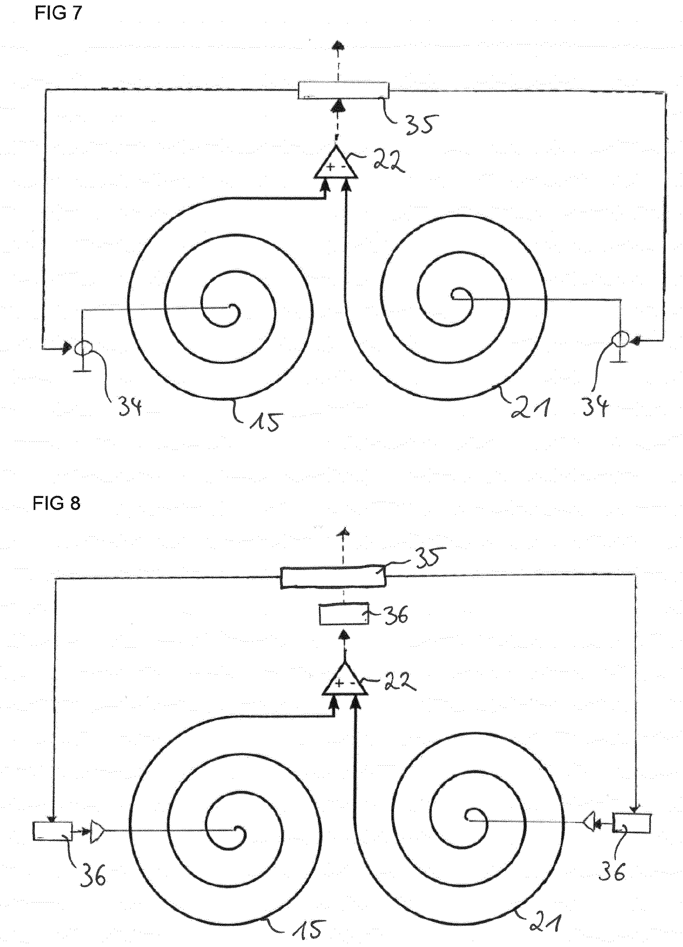

In Figur 7 ist ein weiteres Ausführungsbeispiel der Empfängerspule 15 mit der weiteren Empfängerspule 21 gezeigt. Im Vergleich zu dem in Figur 6 gezeigten Ausführungsbeispiel ist der Differenzverstärker 22 mit einem Regler 35 verbunden. Der Regler 35 ist mit den beiden Spannungsquellen 34 verbunden und dazu ausgelegt die Spannung, die diese bereitstellen, einzustellen. Der Empfänger 14 kann derart betrieben werden, dass das Ausgangssignal des Differenzverstärkers 22 immer Null ergibt. Dies wird dadurch erreicht, dass der Regler 35 für den Fall, dass das Ausgangssignal des Differenzverstärkers 22 verschieden von Null ist, die von den Spannungsquellen 34 bereitgestellten Spannungen derart einstellt, dass das Ausgangssignal des Differenzverstärkers 22 Null ergibt. In diesem Fall entspricht das Regelungssignal des Reglers 35 dem zu detektierenden Signal. Die Verwendung des Reglers 35 ist vorteilhaft, da Temperatureinflüsse auf den Differenzverstärker 22 keinen Einfluss auf das vom Regler 35 ausgegebene Signal haben.

In Figur 8 ist ein weiteres Ausführungsbeispiel der Empfängerspule 15 mit der weiteren Empfängerspule 21 gezeigt. Im Vergleich zu dem in Figur 7 gezeigten Ausführungsbeispiel wird das Ausgangssignal des Differenzverstärkers 22 digitalisiert. Der Differenzverstärker 22 ist mit einem analog-digital-Wandler 36 verbunden, der dazu ausgelegt ist das Ausgangssignal des Differenzverstärkers 22 in ein digitales Signal umzuwandeln. Der analog-digital-Wandler 36 ist mit dem Regler 35 verbunden und dazu ausgelegt, den Regler 35 mit dem digitalisierten Ausgangssignal zu versorgen. Der Regler 35 ist über einen digital-analog-Wandler 36 mit dem anderen Ende der Empfängerspule 15 und über einen weiteren digital-analog-Wandler 36 mit dem anderen Ende der weiteren Empfängerspule 21 verbunden. Somit werden die Enden der Empfängerspule 15 und der weiteren Empfängerspule 21, welche nicht mit dem Differenzverstärker 22 verbunden sind, mit einer Wechselspannung versorgt, welche die gleiche Frequenz wie die Wechselspannung, welche an der Senderspule 12 anliegt, aufweist. Durch die digital-analog-Wandler 36 kann die bereitgestellte Wechselspannung außerdem verstärkt werden. Wie im Ausführungsbeispiel in Figur 7 regelt der Regler 35 die bereitgestellten Wechselspannungen derart, dass das Ausgangssignal des Differenzverstärkers 22 immer Null ergibt. Der Bandpassfilter des Differenzverstärkers 22 wirkt in diesem Fall zusätzlich als Anti-Aliasing Filter für den analog-digital-Wandler 36.

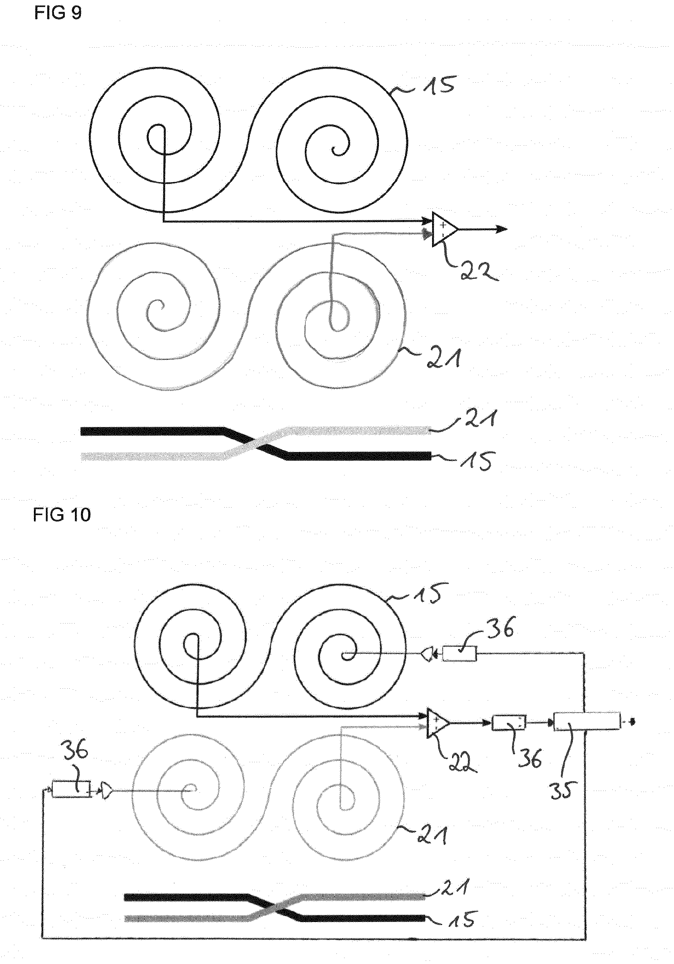

In Figur 9 ist ein weiteres Ausführungsbeispiel der Empfängerspule 15 mit der weiteren Empfängerspule 21 gezeigt. Die Empfängerspule 15 und die weitere Empfängerspule 21 weisen den gleichen Aufbau und den gleichen Wicklungssinn auf. Weiter weisen die Empfängerspule 15 und die weitere Empfängerspule 21 die Form einer Acht mit zwei Spulenhälften auf. Ist eine solche Spule in einem homogenen magnetischen Störfeld angeordnet, so wird in beiden Spulenhälften die gleiche Spannung mit unterschiedlichem Vorzeichen induziert. Somit kompensieren sich die beiden induzierten Spannungen. Die Empfängerspule 15 und die weitere Empfängerspule 21 sind mit dem Differenzverstärker 22 verbunden. Dabei ist bei der Empfängerspule 15 die andere Spulenhälfte im Vergleich zur weiteren Empfängerspule 21 mit dem Differenzverstärker 22 verbunden, so dass sich die in der Empfängerspule 15 und in der weiteren Empfängerspule 21 aufgrund homogener Felder induzierten Spannungen kompensieren. Unterhalb der Empfängerspule 15 und der weiteren Empfängerspule 21 sind die Empfängerspule 15 und die weitere Empfängerspule 21 in einer schematischen Seitenansicht dargestellt. Es ist gezeigt, dass die Empfängerspule 15 und die weitere Empfängerspule 21 versetzt übereinander angeordnet sein können.

Figur 10 zeigt ein weiteres Ausführungsbeispiel der Empfängerspule 15 und der weiteren Empfängerspule 21. Dabei weisen die Empfängerspule 15 und die weitere Empfängerspule 21 den in Figur 9 gezeigten Aufbau auf. Außerdem sind die Empfängerspule 15 und die weitere Empfängerspule 21 wie in Figur 8 gezeigt mit Spannungsquellen 34 und einem Regler 35 verbunden.

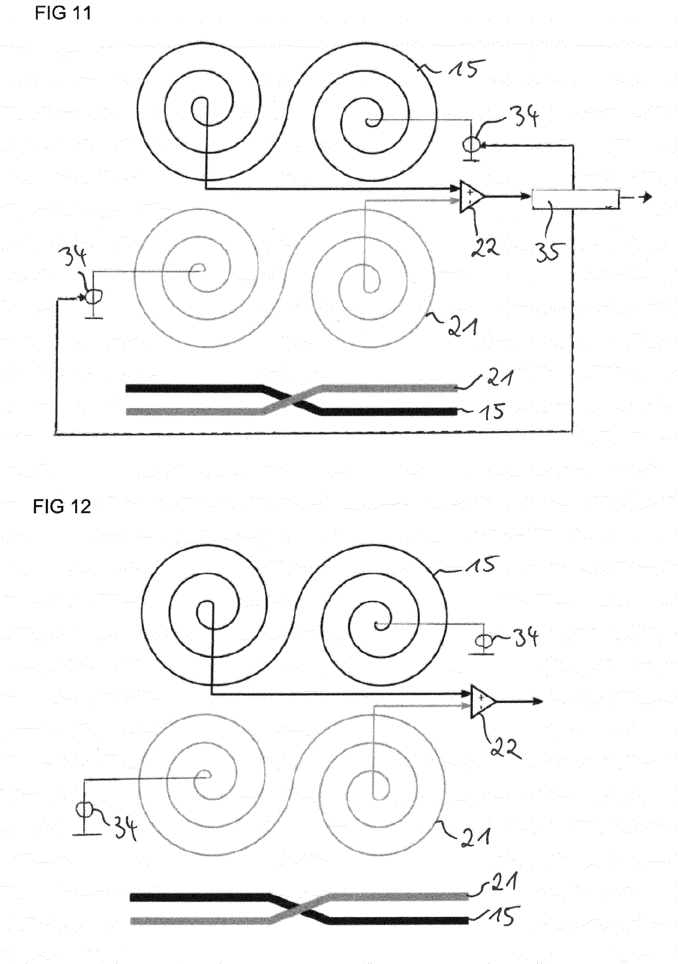

Figur 11 zeigt ein weiteres Ausführungsbeispiel der Empfängerspule 15 und der weiteren Empfängerspule 21. Dabei weisen die Empfängerspule 15 und die weitere Empfängerspule 21 den in Figur 9 gezeigten Aufbau auf. Außerdem sind die Empfängerspule 15 und die weitere Empfängerspule 21 wie in Figur 7 gezeigt mit Spannungsquellen 34 und einem Regler 35 verbunden.

Figur 12 zeigt ein weiteres Ausführungsbeispiel der Empfängerspule 15 und der weiteren Empfängerspule 21. Dabei weisen die Empfängerspule 15 und die weitere Empfängerspule 21 den in Figur 9 gezeigten Aufbau auf. Außerdem sind die Empfängerspule 15 und die weitere Empfängerspule 21 wie in Figur 6 gezeigt mit Spannungsquellen 34 verbunden.

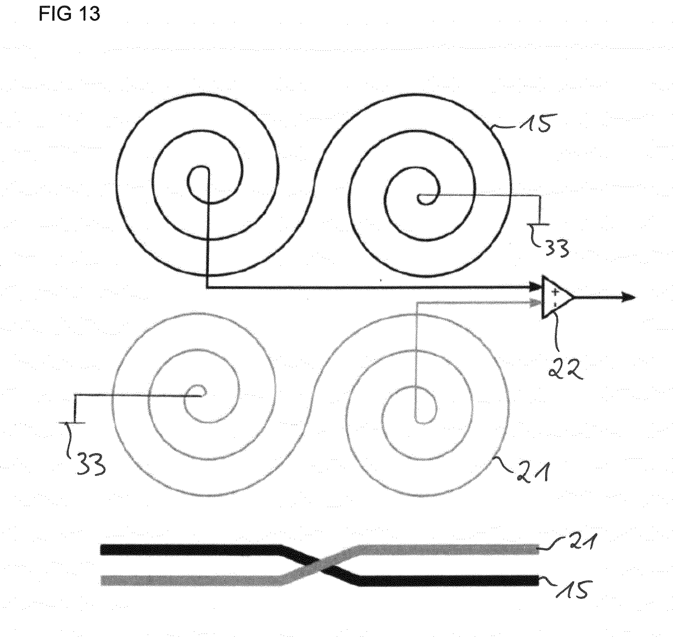

Figur 13 zeigt ein weiteres Ausführungsbeispiel der Empfängerspule 15 und der weiteren Empfängerspule 21. Dabei weisen die Empfängerspule 15 und die weitere Empfängerspule 21 den in Figur 9 gezeigten Aufbau auf. Außerdem sind die Empfängerspule 15 und die weitere Empfängerspule 21 wie in Figur 5 gezeigt jeweils mit einem Bezugspotenzial 33 verbunden.

### Bezugszeichenliste

10: Detektor
11: Sender
12: Senderspule
13: Versorgungsquelle
14: Empfänger
15: Empfängerspule
16: Auswerteeinheit
17: weiterer Sender
18: weitere Senderspule
19: weitere Versorgungsquelle
20: Kondensator
21: weitere Empfängerspule
22: Differenzverstärker
23: erster Anschluss
24: zweiter Anschluss
25: erster Eingang
26: zweiter Eingang
27: erster Ausgang
28: zweiter Ausgang
29: Gegenstand
30: dritter Eingang
31: vierter Eingang
32: Störsignal
33: Bezugspotential
34: Spannungsquelle
35: Regler
36: Wandler

## Patentansprüche

1. Detektor (10) zum Detektieren von elektrisch leitfähigem Material, der Detektor (10) umfassend:
- mindestens einen Sender (11) mit einer Senderspule (12) und einer Versorgungsquelle (13),
- einen Empfänger (14) mit einer Empfängerspule (15), und
- eine Auswerteeinheit (16), wobei
- die Senderspule (12) mit der Versorgungsquelle (13) verbunden ist,
- die Versorgungsquelle (13) dazu ausgelegt ist, im Betrieb eine Wechselspannung oder einen Wechselstrom bereitzustellen,
- der Empfänger (14) als schwingkreisloser Empfänger eingerichtet ist,
- der Empfänger (14) mit der Auswerteeinheit (16) verbunden ist,
- die Auswerteeinheit (16) dazu ausgelegt ist, ein in der Empfängerspule (15) induziertes Signal zu detektieren,
- der Empfänger (14) eine weitere Empfängerspule (21) aufweist,
- die Empfängerspule (15) und die weitere Empfängerspule (21) den gleichen Aufbau und den gleichen Wicklungssinn aufweisen,
- die Auswerteeinheit (16) einen Differenzverstärker (22) aufweist,
- ein Regler (35) mit dem Differenzverstärker (22) verbunden ist,
**dadurch gekennzeichnet dass**
- die Empfängerspule (15) und die weitere Empfängerspule (21) jeweils an einem ihrer Enden mit dem Differenzverstärker (22) verbunden sind und die jeweils anderen Enden der Empfängerspule (15) und der weiteren Empfängerspule (21) jeweils mit einer Spannungsquelle (34) verbunden sind,
- der Empfänger (14) derart betrieben wird, dass die zwei Spannungsquellen (34) jeweils eine Wechselspannung bereitstellen und die Empfängerspule (15) und die weitere Empfängerspule (21) jeweils mit dieser versorgen, und
- die Frequenz dieser Wechselspannung der Frequenz der Wechselspannung entspricht, welche an der Senderspule (12) anliegt.

2. Detektor (10) gemäß Anspruch 1, bei dem im Betrieb die von der Versorgungsquelle (13) bereitgestellte Wechselspannung oder der von der Versorgungsquelle (13) bereitgestellte Wechselstrom in die Senderspule (12) eingekoppelt wird.

3. Detektor (10) gemäß einem der vorherigen Ansprüche, bei dem die Senderspule (12) durch das Anlegen einer Spannung oder eines Stroms an die Senderspule (12) ein Sendermagnetfeld erzeugt.

4. Detektor (10) gemäß einem der vorherigen Ansprüche, bei dem die Senderspule (12) und die Empfängerspule (15) derart angeordnet sind, dass ein von der Senderspule (12) erzeugtes Sendermagnetfeld ein Signal in der Empfängerspule (15) induziert.

5. Detektor (10) gemäß einem der vorherigen Ansprüche, bei dem die Auswerteeinheit (16) dazu ausgelegt ist, ein Ausgangssignal bereitzustellen, das von einer Änderung des in der Empfängerspule (15) induzierten Signals abhängt.

6. Detektor (10) gemäß einem der vorherigen Ansprüche, bei dem die Auswerteeinheit (16) dazu ausgelegt ist, die Amplitude und/oder die Phase des in der Empfängerspule (15) induzierten Signals zu bestimmen.

7. Detektor (10) gemäß einem der vorherigen Ansprüche, bei dem der Detektor (10) einen weiteren Sender (17) mit einer weiteren Senderspule (18) und einer weiteren Versorgungsquelle (19) aufweist.

8. Detektor (10) gemäß dem vorherigen Anspruch, bei dem die weitere Versorgungsquelle (19) dazu ausgelegt ist im Betrieb eine Wechselspannung oder einen Wechselstrom bereitzustellen, deren oder dessen Frequenz verschieden von der Frequenz der von der Versorgungsquelle (13) bereitgestellten Wechselspannung oder des von der Versorgungsquelle (13) bereitgestellten Wechselstroms ist.

9. Detektor (10) gemäß einem der vorherigen Ansprüche, bei dem der Sender (11) einen Kondensator (20) aufweist, welcher mit der Senderspule (12) einen Schwingkreis bildet.

10. Detektor (10) gemäß einem der vorherigen Ansprüche, bei dem der Differenzverstärker (22) dazu ausgelegt ist ein Ausgangssignal bereitzustellen, wobei das Ausgangssignal von der Amplitude und der Phase des in der Empfängerspule (15) induzierten Signals und von der Amplitude und der Phase des in der weiteren Empfängerspule (21) induzierten Signals abhängt.

11. Detektor (10) gemäß einem der vorherigen Ansprüche, bei dem der Regler (35) mit den beiden Spannungsquellen (34) verbunden ist und dazu ausgelegt ist die Spannung, die diese bereitstellen, einzustellen, wobei der Regler (35) für den Fall, dass das Ausgangssignal des Differenzverstärkers (22) verschieden von Null ist, die von den Spannungsquellen (34) bereitgestellten Spannungen derart einstellt, dass das Ausgangssignal des Differenzverstärkers (22) Null ergibt.

12. Detektor (10) gemäß einem der vorherigen Ansprüche, bei dem die Empfängerspule (15) und die weitere Empfängerspule (21) die Form einer Acht mit zwei Spulenhälften aufweisen.

13. Detektor (10) gemäß einem der vorherigen Ansprüche, bei dem die Empfängerspule (15) und die weitere Empfängerspule (21) versetzt übereinander angeordnet sind.

14. Detektor (10) gemäß einem der vorherigen Ansprüche, bei dem die Kopplung zwischen der Senderspule (12) und der Empfängerspule (15) weniger als 5 % beträgt.

## Claims

1. A detector (10) for detecting electrically conductive material, the detector (10) comprising:
- at least one transmitter (11) having a transmitter coil (12) and a supply source (13),
- a receiver (14) having a receiver coil (15), and
- an evaluation unit (16), wherein
- the transmitter coil (12) is connected to the supply source (13),
- the supply source (13) is configured to provide an alternating voltage or an alternating current when in use,
- the receiver (14) is designed as a resonant-circuit-free receiver,
- the receiver (14) is connected to the evaluation unit (16),
- the evaluation unit (16) is configured to detect a signal induced in the receiver coil (15),
- the receiver (14) has an additional receiver coil (21),
- the receiver coil (15) and the additional receiver coil (21) have the same construction and the same winding direction,
- the evaluation unit (16) has a differential amplifier (22),
- a controller (35) is connected to the differential amplifier (22),
**characterized in that**
- the receiver coil (15) and the additional receiver coil (21) each have one of their ends connected to the differential amplifier (22), and the respective other ends of the receiver coil (15) and the additional receiver coil (21) are each connected to a voltage source (34),
- the receiver (14) is operated in such a way that the two voltage sources (34) each provide an alternating voltage and the receiver coil (15) and the additional receiver coil (21) are each supplied with this voltage, and
- the frequency of this alternating voltage is the same as the frequency of the alternating voltage applied to the transmitter coil (12).

2. The detector (10) according to claim 1, in which in use the alternating voltage supplied by the supply source (13) or the alternating current supplied by the supply source (13) is coupled into the transmitter coil (12).

3. The detector (10) according to any of the preceding claims, in which the transmitter coil (12) generates a transmitter magnetic field by applying a voltage or a current to the transmitter coil (12).

4. The detector (10) according to any of the preceding claims, in which the transmitter coil (12) and the receiver coil (15) are arranged such that a transmitter magnetic field generated by the transmitter coil (12) induces a signal in the receiver coil (15).

5. The detector (10) according to any of the preceding claims, in which the evaluation unit (16) is configured to provide an output signal, which depends on a change in the signal induced in the receiver coil (15).

6. The detector (10) according to any of the preceding claims, in which the evaluation unit (16) is configured to determine the amplitude and/or the phase of the signal induced in the receiver coil (15).

7. The detector (10) according to any of the preceding claims, in which the detector (10) comprises an additional transmitter (17) which has an additional transmitter coil (18) and an additional supply source (19).

8. The detector (10) according to the preceding claim, in which the additional supply source (19), when in use, is configured to provide an alternating voltage or an alternating current, the frequency of which differs from the frequency of the alternating voltage provided by the supply source (13) or from the alternating current provided by the supply source (13).

9. The detector (10) according to any of the preceding claims, in which the transmitter (11) comprises a capacitor (20) which forms an oscillating circuit together with the transmitter coil (12).

10. The detector (10) according to any of the preceding claims, in which the differential amplifier (22) is configured to provide an output signal, wherein the output signal depends on the amplitude and the phase of the signal induced in the receiver coil (15) and on the amplitude and the phase of the signal induced in the additional receiver coil (21).

11. The detector (10) according to any of the preceding claims, in which the controller (35) is connected to the two voltage sources (34) and is configured to adjust the voltage they provide, wherein the controller (35) adjusts the voltages provided by the voltage sources (34) such that the output signal of the differential amplifier (22) is zero, in the event that the output signal of the differential amplifier (22) is different from zero.

12. The detector (10) according to any of the preceding claims, in which the receiver coil (15) and the additional receiver coil (21) have the shape of a figure eight with two coil halves.

13. The detector (10) according to any of the preceding claims, in which the receiver coil (15) and the additional receiver coil (21) are arranged offset one above the other.

14. The detector (10) according to any of the preceding claims, in which the coupling between the transmitter coil (12) and the receiver coil (15) is less than 5%.

## Revendications

1. Détecteur (10) servant à détecter du matériau électriquement conducteur, le détecteur (10) comprenant :
- au moins un émetteur (11) comportant une bobine d'émetteur (12) et une source d'alimentation (13),
- un récepteur (14) comportant une bobine de récepteur (15), et
- une unité d'évaluation (16), sachant que
- la bobine d'émetteur (12) est reliée à la source d'alimentation (13),
- la source d'alimentation (13) est conçue pour mettre à disposition, en fonctionnement, une tension alternative ou un courant alternatif,
- le récepteur (14) est configuré comme récepteur sans circuit oscillant,
- le récepteur (14) est relié à l'unité d'évaluation (16),
- l'unité d'évaluation (16) est conçue pour détecter un signal induit dans la bobine de récepteur (15),
- le récepteur (14) présente une bobine de récepteur (21) supplémentaire,
- la bobine de récepteur (15) et la bobine de récepteur (21) supplémentaire présentent la même structure et le même sens d'enroulement,
- l'unité d'évaluation (16) présente un amplificateur différentiel (22),
- un régleur (35) est relié à l'amplificateur différentiel (22),
**caractérisé en ce que**
- la bobine de récepteur (15) et la bobine de récepteur (21) supplémentaire sont reliées respectivement à l'amplificateur différentiel (22) à une de leurs extrémités et les respectivement autres extrémités de la bobine de récepteur (15) et de la bobine de récepteur (21) supplémentaire sont reliées respectivement à une source de tension (34),
- le récepteur (14) est exploité de telle manière que les deux sources de tension (34) mettent à disposition respectivement une tension alternative et alimentent respectivement en celle-ci la bobine de récepteur (15) et la bobine de récepteur (21) supplémentaire, et
- la fréquence de cette tension alternative correspond à la fréquence de la tension alternative qui est présente au niveau de la bobine d'émetteur (12).

2. Détecteur (10) selon la revendication 1, sachant que, en fonctionnement, la tension alternative mise à disposition par la source d'alimentation (13) ou le courant alternatif mis à disposition par la source d'alimentation (13) est injecté(e) dans la bobine d'émetteur (12).

3. Détecteur (10) selon l'une des revendications précédentes, sachant que la bobine d'émetteur (12) génère un champ magnétique d'émetteur par l'application d'une tension ou d'un courant à la bobine d'émetteur (12).

4. Détecteur (10) selon l'une des revendications précédentes, sachant que la bobine d'émetteur (12) et la bobine de récepteur (15) sont disposées de telle manière qu'un champ magnétique d'émetteur généré par la bobine d'émetteur (12) induise un signal dans la bobine de récepteur (15) .

5. Détecteur (10) selon l'une des revendications précédentes, sachant que l'unité d'évaluation (16) est conçue pour mettre à disposition un signal de sortie qui dépend d'un changement du signal induit dans la bobine de récepteur (15).

6. Détecteur (10) selon l'une des revendications précédentes, sachant que l'unité d'évaluation (16) est conçue pour déterminer l'amplitude et/ou la phase du signal induit dans la bobine de récepteur (15).

7. Détecteur (10) selon l'une des revendications précédentes, sachant que le détecteur (10) présente un émetteur (17) supplémentaire comportant une bobine d'émetteur (18) supplémentaire et une source d'alimentation (19) supplémentaire.

8. Détecteur (10) selon la revendication précédente, sachant que la source d'alimentation (19) supplémentaire est conçue pour mettre à disposition, en fonctionnement, une tension alternative ou un courant alternatif dont la fréquence diffère de la fréquence de la tension alternative mise à disposition par la source d'alimentation (13) ou du courant alternatif mis à disposition par la source d'alimentation (13).

9. Détecteur (10) selon l'une des revendications précédentes, sachant que l'émetteur (11) présente un condensateur (20), lequel forme un circuit oscillant avec la bobine d'émetteur (12).

10. Détecteur (10) selon l'une des revendications précédentes, sachant que l'amplificateur différentiel (22) est conçu pour mettre à disposition un signal de sortie, sachant que le signal de sortie dépend de l'amplitude et de la phase du signal induit dans la bobine de récepteur (15) et de l'amplitude et de la phase du signal induit dans la bobine de récepteur (21) supplémentaire.

11. Détecteur (10) selon l'une des revendications précédentes, sachant que le régleur (35) est relié aux deux sources d'alimentation (34) et est conçu pour régler la tension que celles-ci mettent à disposition, sachant que le régleur (35), pour le cas où le signal de sortie de l'amplificateur différentiel (22) est différent de zéro, règle les tensions mises à disposition par les sources de tension (34) de telle manière que le signal de sortie de l'amplificateur différentiel (22) soit égal à zéro.

12. Détecteur (10) selon l'une des revendications précédentes, sachant que la bobine de récepteur (15) et la bobine de récepteur (21) supplémentaire présentent la forme d'un huit avec deux moitiés de bobine.

13. Détecteur (10) selon l'une des revendications précédentes, sachant que la bobine de récepteur (15) et la bobine de récepteur (21) supplémentaire sont disposées de manière décalée l'une au-dessus de l'autre.

14. Détecteur (10) selon l'une des revendications précédentes, sachant que le couplage entre la bobine d'émetteur (12) et la bobine de récepteur (15) est de moins de 5 %.
